# EUROPÄISCHE PATENTANMELDUNG

(11) **EP 1 148 544 A1**
(43) Veröffentlichungstag der Anmeldung: **24.10.2001**
(21) Anmeldenummer: 00108571.1
(22) Anmeldetag: 19.04.2000
(51) Int. Cl.: H01L 21/822, H01L 21/306

(54) **Verfahren zum Dünnen eines Substrats**

(71) Anmelder: Infineon Technologies AG, 81541 München (DE)
(72) Erfinder: Hübner, Holger, Dr., 85598 Baldham (DE); Schäfer, Herbert, Dr., 85635 Höhenkirchen-Siegertsbrunn (DE)
(74) Vertreter: Hermann, Uwe, Dipl.-Ing.

(57) **Zusammenfassung**

Die vorliegende Erfindung betrifft ein Verfahren zum hochgenauen und schnellen Dünnen von einem Halbleitersubstrat, das unabhängig von der Toleranz eines Montageträgers (8) und einer Klebefuge (7), mit der das Substrat an dem Montageträger (8) befestigt wird, ausgeführt werden kann. Dazu wird in dem Substrat (1) eine erste dotierte Schicht (2) mit p-Dotierstoff gebildet. Anschließend wird das Substrat (1) zunächst von seiner Rückseite (9) abgeschliffen und naßchemisch weiter zurückgeätzt. Dabei dient die erste dotierte Schicht (2) als Ätzstopp.

## Beschreibung

Die vorliegende Erfindung betrifft ein Verfahren zur Dünnung eines Halbleitersubstrats.

Bei der dreidimensionalen Integration von integrierten Schaltungen wird ein gedünntes Halbleitersubstrat auf einem zweiten Halbleitersubstrat angeordnet und mit diesem mechanisch und elektrisch verbunden. Dieses Verfahren wird beispielsweise in "Semiconductor Wafer Bonding: Science and Technology, Q.Y. Tong, Wiley-Interscience Publication" auf den Seiten 146 bis 153, beschrieben. Bei diesem Verfahren ist der Dünnungsprozeß des Halbleitersubstrats einer der technologisch anspruchsvollsten und teuersten Prozeßschritte.

Für die dreidimensionale Integration werden üblicherweise zunächst zwei fertig prozessierte Wafer bereitgestellt. Der erste Wafer dient dabei als Träger, der zweite Wafer wird mit dem folgenden Verfahren gedünnt und auf dem ersten Wafer angeordnet. Zur Dünnung wird zunächst der zweite Wafer auf seiner Vorderseite, bei der es sich um die Seite mit den elektrischen Schaltkreisen handelt, mit einer Klebeschicht versehen und mit einem Montageträger verbunden. Der zweite Wafer wird dann von seiner Rückseite her gedünnt, wobei üblicherweise bis zu drei Verfahren sequentiell zur Anwendung kommen. Als erstes wird meist ein Schleifverfahren verwendet, an das sich ein chemisches Ätzverfahren und ein chemisch-mechanisches Polieren (CMP) anschließt. Ziel dieses Verfahrens ist eine Restdicke des Halbleitersubstrats im Bereich von 10 *µ*m zu erhalten, wobei unter Berücksichtigung der folgenden Prozeßschritte besonders auf die Planarität und die exakte Einhaltung der Zieldicke Wert gelegt werden muß.

Die drei genannten Dünnungsverfahren beinhalten aufgrund ihrer unterschiedlichen Arbeitsweisen jeweils unterschiedliche Nachteile, so daß das beste Ergebnis durch eine Kombination der bekannten Verfahren erreicht wird. Das Schleifen ist das schnellste Verfahren und wird deshalb als erster Schritt eingesetzt, um den größten Teil der Halbleiterschicht abzutragen. Allerdings erfährt die Substratoberfläche Schädigungen durch das Schleifen, die in einem anschließenden chemischen Ätzschritt abgetragen werden. Der chemische Ätzschritt hat allerdings den Nachteil, daß die geätzte Oberfläche nicht planar ist, sondern eine Welligkeit im Bereich von +/-3 % der durch den Ätzschritt abgetragenen Schichtdicke aufweist. Aus diesem Grund wird in einem dritten Schritt ein chemischmechanisches Polieren CMP durchgeführt, wodurch die Welligkeit der Oberfläche auspoliert wird. Der CMP-Schritt ist langsam und teuer und wird deshalb nur zur Nachbehandlung der Oberfläche eingesetzt.

Als Verfahren mit dem größten Abtrag wird das mechanische Schleifen eingesetzt. Der Schleifabtrag stellt sich durch die Justierung der Anlage planparallel zu dem Montageträger ein, an dem der zweite Substratwafer befestigt ist. Hierbei ist zu berücksichtigen, daß ein nicht planparallel zum Montageträger befestigter Wafer schräg abgeschliffen wird. Da der Substratwafer beispielsweise mit Klebstoff an dem Montageträger befestigt wird, befindet sich zwischen dem Substrat und dem Montageträger eine Klebefuge. Weist die Klebefuge eine unterschiedliche Schichtdicke auf, wie sie z.B. bei einer Keilform ausgebildet ist, so ist das Substrat nicht planparallel zu dem Montageträger ausgerichtet. Beim anschließenden Schleifprozeß wird der Substratwafer daher nicht planparallel zu seiner Oberfläche abgeschliffen, auf der die elektrischen Schaltkreise angeordnet sind. Dieses Problem kann beispielsweise dadurch gelöst werden, daß die Klebefuge sehr dünn ausgebildet wird. Dies hat jedoch den Nachteil, daß keine gefüllten Kleber verwendet werden können, die beim späteren Ablösen des Substrats von dem Montageträger vorteilhaft wären, da z.B. Lösungsmittel den Kleber aus dicken Klebefugen leichter herauslösen kann. Ebenfalls geht die Justiergenauigkeit des Montageträgers gegenüber der Schleifplatte in die Genauigkeit des Schleifprozesses ein.

Andererseits kann auf den Schleifprozeß nicht verzichtet werden, da Ätzprozesse zu ungenau und CMP zu langsam ist.

Es ist beispielsweise ein Verfahren bekannt, bei dem eine vergrabene Oxidschicht als Ätzstopp verwendet wird. Wafer, die eine solche vergrabene Oxidschicht aufweisen, sind als sogenannte SOI-Wafer (silicon on insulator) bekannt. Diese Wafer sind wesentlich teurer als Standardwafer und erfordern eine veränderte Prozeßführung bei der Herstellung von Schaltkreisen in dem Siliziumsubstrat gegenüber herkömmlichen Siliziumwafern. Dies macht eine Anpassung der Prozeßtechnologie erforderlich. Besonders nachteilig bei SOI-Wafern ist, daß sie große innere mechanische Spannungen aufweisen. Werden SOI-Wafer auf wenige 10 *µ*m und darunter gedünnt, so führt dies zum Abschälen der Siliziumschicht von dem Montageträger und zum Aufrollen der Siliziumschicht.

Es ist die Aufgabe der Erfindung ein Verfahren anzugeben, mit dem ein Halbleitersubstrat hochgenau und schnell gedünnt werden kann.

Erfindungsgemäß wird die Aufgabe gelöst durch ein Verfahren zum Dünnen eines Substrats mit den Schritten:
- Bereitstellen eines Substrats mit einer Vorderseite und einer Rückseite;
- Bilden einer Nutzschicht auf der Vorderseite des Substrats;
- Bilden einer ersten dotierten Schicht in dem Substrat;
- naßchemisches Ätzen des Substrates, wobei das Substrat von der Rückseite gedünnt wird und die erste dotierte Schicht als Ätzstopp verwendet wird.

Durch die erfindungsgemäße Verwendung einer dotierten Schicht in dem Substrat als Ätzstopp wird in vorteilhafter Weise ein selbstjustierter Prozeßschritt zum Dünnen des Substrats verwendet. Die Ätzung der Waferrückseite stoppt in diesem Fall selbstjustiert an der dotierten Schicht, so daß selbst bei schrägem Anschleifen der Waferrückseite eine planparallele Ausrichtung von der Vorderseite mit den Schaltkreisen zu der Rückseite des gedünnten Wafers erreicht wird. Es ist z.B. aus "Q.Y. Tong, Semiconductor Wafer Bonding: Science and Technology," Seite 146 bis 153, bekannt, daß p-dotiertes Silizium für Naßätzlösungen wie z.B. KOH-Lösung (Kaliumhydroxid) oder EDT-Lösung (Ethylendiamin-Pyrokatechol-Wasser) als Ätzstopp wirken, da die p-Dotierung die für die Ätzung wesentlichen freien Elektroden wegfängt. Dieses Phänomen ist Grundlage der Mikromechanik und wird dort seit langem ausführlich untersucht und angewandt. Die vorliegende Erfindung basiert folglich darauf, daß eine hoch-p-dotierte Ätzstoppschicht unter der Nutzschicht, die zur Herstellung der integrierten Schaltung dient, vergraben wird. Als Substrat sind neben Silizium auch alle weitere bekannten Halbleitersubstrate wie Gallium-Arsenid, Gallium-Alluminium-Arsenid, Indium-Phosphid, Alluminium-Antimonid, Gallium-Nitrid, Gallium-Phosphit etc. geeignet.

In einem weiteren Verfahrensschritt ist vorgesehen, daß die erste dotierte Schicht epitaktisch auf die Vorderseite des Substrats aufgewachsen wird. Das Aufwachsen einer epitaktischen Dotierschicht hat den Vorteil, daß eine sehr gute Einkristallinität mit geringer Defektdichte des Substrats gewährleistet wird.

Darüber hinaus ist vorgesehen, daß eine weitere Schicht epitaktisch auf die erste dotierte Schicht aufgewachsen wird. Die weitere Schicht ist dazu vorgesehen, daß in ihr elektrische Schaltkreise z.B. in CMOS-Technologie (complementary metal oxide semiconductor) gebildet werden.

Es ist weiterhin vorgesehen, daß die erste dotierte Schicht durch Implantation von Dotierstoff in dem Substrat gebildet wird. Die Implantation von Dotierstoff ermöglicht die Bildung einer vergrabenen dotierten Schicht auch ohne epitaktisches Aufwachsen.

Ein weiterer Verfahrensschritt sieht vor, daß eine zweite dotierte Schicht zwischen der Vorderseite des Substrats und der ersten dotierten Schicht gebildet wird, wobei die zweite dotierte Schicht mit einem zweiten Dotierstofftyp dotiert wird, der dem ersten Dotierstofftyp der ersten dotierten Schicht entgegengesetzt ist. Da die erste dotierte Schicht bei einem thermisch angetriebenen Diffusionsschritt ausdiffundiert und somit Dotierstoff aus der dotierten Schicht in die darüberliegende weitere Schicht diffundiert, werden die Eigenschaften der Schicht verändert. Dies wird durch die zweite dotierte Schicht kompensiert, die eine Gegendotierung aufweist. Dazu wird die zweite dotierte Schicht mit einer Dotierstoffkonzentration gebildet, die geringer als die Dotierstoffkonzentration der ersten Dotierschicht ist und zwischen der Vorderseite des Substrats und der ersten dotierten Schicht angeordnet ist. Durch diese Anordnung wird die Dotierung der ausdiffundierten ersten dotierten Schicht durch die Dotierung der zweiten Dotierschicht kompensiert.

Ein weiterer Verfahrensschritt sieht vor, daß die zweite dotierte Schicht als eine Gegendotierung für die erste dotierte Schicht gebildet wird. Durch die Gegendotierung erscheint die dotierte Schicht in dem Bereich der Gegendotierung als neutral dotiert.

Darüber hinaus sieht ein Verfahrensschritt vor, daß eine Maske auf der Vorderseite des Substrats gebildet wird und als Implantationsmaske für die Bildung der dotierten Schicht verwendet wird, so daß die dotierte Schicht strukturiert ausgebildet wird. Die strukturiert ausgebildete dotierte Schicht hat den Vorteil, daß sie nur in den dotierten Bereichen als Ätzstoppmaske wirkt, so daß mit dem Rückseitenätzprozeß eine Strukturierung durchgeführt werden kann, die die dotierten Bereiche stehen läßt und die nicht-dotierten Bereiche wegätzt.

Weiterhin ist vorgesehen, daß die Rückseite des Substrats geätzt wird, wobei die strukturierte dotierte Schicht als Ätzmaske verwendet wird und dadurch auf dem Substrat angeordnete Chips voneinander separiert werden. Durch diesen Verfahrensschritt kann z.B. ein nachfolgender Sägeprozeß eingespart werden, bei dem die einzelnen Chips durch Sägen aus dem Waferverbund herausgelöst werden.

Weiterhin ist vorgesehen, daß die Rückseite des Substrats geätzt wird, wobei die strukturierte dotierte Schicht als Ätzmaske verwendet wird und dadurch der Rand des Substrats entfernt wird. Da der gedünnte Wafer üblicherweise auf einem Trägerwafer angeordnet und mit diesem elektrisch verbunden wird, stellt der Rand des gedünnten und auf den Trägerwafer gebondeten Wafer eine exponierte, empfindliche Stelle dar. Durch Entfernen dieses Randes wird der gedünnte, auf dem Trägerwafer befestigte Wafer vor mechanischer Beanspruchung und Zerstörung geschützt.

In einem weiteren vorteilhaften Verfahrensschritt wird die dotierte Schicht mit Bor p-dotiert. Das Einbringen einer Bordotierung ermöglicht die Verwendung von KOH bzw. EDT als Ätzsubstanzen.

Eine weitere vorteilhafte Ausgestaltung des erfindungsgemäßen Verfahrens sieht vor, daß die dotierte Schicht mit Germanium dotiert wird. Germanium kann ebenfalls als Ätzstopp verwendet werden, da es in dem Substrat Verspannungen induziert. Weiterhin kann Germanium dazu verwendet werden, Verspannungen, die aufgrund der Bordotierung auftreten auszugleichen. Da Bor einen kleineren Atomradius als Silizium und Germanium einen größeren Atomradius als Silizium aufweist, führt dies zu einer Kompensation der Verspannungen.

Ein weiterer vorteilhafter Verfahrensschritt sieht vor, daß die dotierte Schicht mit Stickstoff dotiert wird. Stickstoff kann ebenfalls als Ätzstopp verwendet werden, da sich Stickstoff mit Silizium zu Siliziumnitrid verbindet und für geeignete Ätzsubstanzen nicht ätzbar ist.

Eine weitere Verfahrensvariante sieht vor, daß die dotierte Schicht mit Kohlenstoff dotiert wird. Kohlenstoff verbindet sich mit Silizium zu Siliziumkarbid und wirkt ebenfalls für geeignete Ätzmittel als Ätzstopp.

In einem weiteren Verfahrensschritt ist vorgesehen, daß auf der Vorderseite des Substrats eine Schaltung gebildet wird. Die Schaltung wird üblicherweise in CMOS-Technologie gefertigt, die kompatibel zu der hier angegebenen Substratdünnung ist.

Ein weiterer vorteilhafter Verfahrensschritt sieht vor, daß das Substrat mit seiner Oberfläche an einem Träger befestigt wird. Die Befestigung des Substrats mit seiner Oberfläche an einem Träger ermöglicht, daß das Substrat von seiner Rückseite her gedünnt wird. Zur Befestigung wird üblicherweise ein Klebstoff verwendet.

Weiterhin ist vorgesehen, daß die Rückseite des Substrats abgeschliffen wird. Das Abschleifen des Substrats hat den Vorteil, daß ein schneller und kostengünstiger Materialabtrag von der Rückseite des Substrats erfolgt.

Ein weiterer vorteilhafter Verfahrensschritt sieht vor, daß die Rückseite des Substrats geätzt wird. Das Ätzen der Substratrückseite wird z.B. nach dem Abschleifen der Substratrückseite durchgeführt, um Substratschädigungen zu beseitigen, die durch das Schleifen entstanden sind.

Weitere vorteilhafte Ausgestaltungen der Erfindung sind in den abhängigen Ansprüchen angegeben.

Nachfolgend wird die Erfindung anhand von Ausführungsbeispielen und Figuren näher erläutert.

In den Figuren zeigen:
- Figur 1: ein Substrat mit dotierten Schichten, das an einem Montageträger befestigt ist;
- Figur 2: eine Dotierstoffkonzentration, die über dem Substratquerschnitt aufgezeichnet ist.

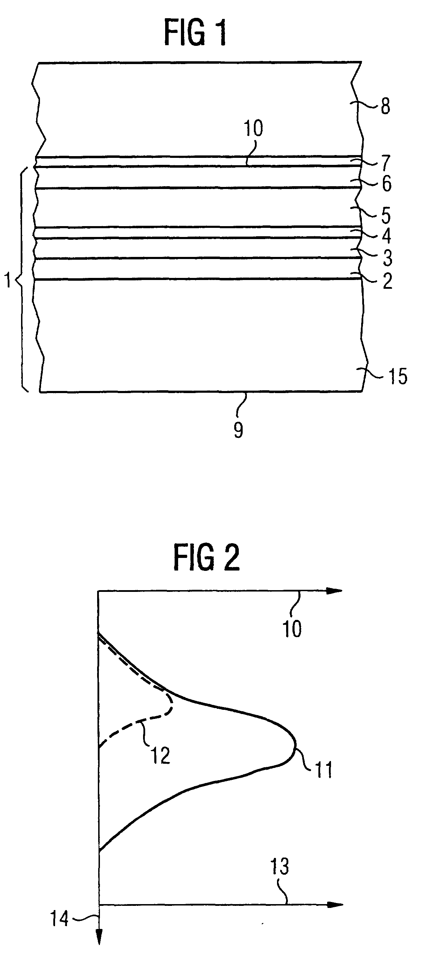

In Figur 1 ist ein Substrat 1 dargestellt, das eine erste dotierte Schicht 2 aufweist. Oberhalb der ersten dotierten Schicht 2 ist eine weitere Schicht 3 angeordnet. Oberhalb der weiteren Schicht 3 ist eine zweite dotierte Schicht 4 angeordnet. In diesem Ausführungsbeispiel weist die erste dotierte Schicht 2 eine p-Dotierung und die zweite dotierte Schicht 4 eine n-Dotierung auf. Das Substrat ist in diesem Ausführungsbeispiel aus Silizium gebildet. Auf der zweiten dotierten Schicht 4 ist eine Nutzschicht 5 angeordnet, auf der eine Schaltungselementeschicht 6 gebildet ist. Die Schaltungselementeschicht 6 umfaßt beispielsweise CMOS-Bauelemente, Widerstände und Kondensatoren. An der Schaltungselementeschicht 6 ist die Vorderseite 10 des Substrats 1 angeordnet. Die Rückseite 9 ist auf der gegenüberliegenden Seite des Substrats 1 angeordnet. Bei der in Figur 1 dargestellten Anordnung ist die Schaltungselementeschicht 6 mittels einer Klebeschicht 7 mit einem Montageträger 8 verbunden. Der angegebene Schichtstapel ist dabei auf dem unteren Substratteil 15 gebildet.

Eine geeignete erste dotierte Schicht 2 und zweite dotierte Schicht 4 läßt sich z.B. mittels epitaktischer Abscheidung unter Zugabe geeigneter Dotierstoffe aufbringen. Dazu wird auf das Ausgangssubstrat 15 zunächst in einer Epitaxieanlage eine bordotierte Schicht mit einem CVD-Verfahren (chemical vapor deposition) aufgewachsen. Als Precursor (Prozeßgase) kommen beispielsweise Silan, Dichlorsilan, Trichlorsilan oder Tetrachlorsilan in Betracht, um den Siliziumanteil für das CVD-Verfahren bereitzustellen. Die Abscheidetemperatur liegt dabei zwischen 600°C und 1200°C und der Druck zwischen 1 und 760 Torr. Je nach Dotierung der epitaktisch aufgewachsenen Dotierschicht wird der Dotierstoff ebenfalls in Gasform zugeführt. Für eine Bordotierung wird Diboran, für eine Phosphordotierung Phosphin und für eine Arsendotierung Arsin mit dem Trägergas Wasserstoff in die Epitaxieanlage eingeleitet. Damit lassen sich Abscheideraten von mehreren *µ*m pro Minute erzielen.

Bei der epitaktischen Aufscheidung wird zunächst die erste dotierte Schicht 2 als bordotierte Ätzstoppschicht mit einer Dicke von mindestens 150 nm, bevorzugt jedoch 0,5 bis 2 *µ*m gebildet. Die Dotierung wird zwischen 5 x 10¹⁸ bis 5 x 10²⁰ pro cm³ gebildet. Anschließend wird eine weitere Siliziumschicht 3 abgeschieden. Auf die weitere Siliziumschicht 3 wird eine zweite dotierte Schicht 4 mit n-Dotierstoff abgeschieden. Dazu wird ebenfalls ein epitaktisches CVD-Verfahren, allerdings unter Verwendung von Phosphin bzw. Arsin verwendet. Durch die zweite dotierte Schicht 4 wird die Dotierung der ersten dotierten Schicht 2 teilweise kompensiert. Auf die zweite dotierte Schicht 4 wird anschließend eine Siliziumnutzschicht 5 mit einer Dicke von bis zu 50 *µ*m aufgewachsen. Vorteilhafterweise kann hier eine geringere Dicke bis 15 *µ*m gewählt werden, um die Dicke des gedünnten Wafers klein zu gestalten. In der Nutzschicht 5 wird nun die Schaltungselementeschicht 6 gebildet, indem integrierte Schaltungen wie CMOS-Transistoren, Widerstände und Kondensatoren auf herkömmliche Weise in der Nutzschicht 5 gebildet werden. Nach Fertigstellung der Schaltungselemente in der Schaltungselementeschicht 6 wird der in Figur 1 dargestellte Wafer gedünnt. Dazu wird das Substrat 1 mittels einer Klebeschicht 7 mit einem Montageträger 8 verklebt und durch einen Schleifprozeß auf ca. 50 *µ*m grob gedünnt. Die grobe Dünnung kann durchaus einen dickeren bzw. dünneren Substratrest übrig lassen, es ist jedoch darauf zu achten, daß die erste dotierte Schicht 2 nicht vollständig entfernt wird, da sie in diesem Fall nicht mehr als Ätzstopp wirken kann. Als zweiter Dünnungsschritt wird nun ein Naßätzprozeß mit KOH oder EDT durchgeführt, da dieser Ätzprozeß hochselektiv zu der ersten dotierten Schicht 2 durchgeführt werden kann und auf ihr stoppt. Durch dieses Verfahren kann eine Verkippung des Substrats 1, die ein schräges Anschleifen des Substrats 1 zur Folge hat, korrigiert werden. Anschließend kann durch einen konventionellen Ätzprozeßschritt die erste Dotierschicht 2, die weitere Schicht 3 und die zweite dotierte Schicht 4 entfernt werden, um spätere unerwünschte Diffusion von Dotierstoffen beim Betrieb der Schaltung zu vermeiden.

Alternativ kann die dotierte Schicht 2 im Wafer durch eine Implantation von Dotierstoffatomen erreicht werden. Dazu kann beispielsweise eine Implantationsenergie von 2,5 MeV verwendet werden, so daß das Maximum der Dotierstoffkonzentration von Bor in einer Tiefe von ca. 3,5 *µ*m unter der Siliziumoberfläche 10 liegt. Mit diesem Verfahren können beispielsweise extrem dünne Substrate hergestellt werden. Dazu wird das Substrat zunächst mit einer Bordotierstoffimplantation mit einer Implantationsenergie von 2,5 MeV und einer Dotierstoffkonzentration von 10²⁰ Boratomen pro cm³ implantiert. Direkt an der Substratoberfläche 10 ist die Borkonzentration um ca. vier Größenordnungen geringer und stört damit den normalen Fertigungsprozeß der Schaltungselementeschicht 6 nicht. Gegebenenfalls kann eine Wannenimplantation durchgeführt werden, um die Bauelemente der Schaltungselementeschicht 6 an die vergrabene erste dotierte Schicht 2 anzupassen, die mit Bor dotiert ist.

Alternativ kann eine Ätzstoppschicht auch durch Implantation von Germanium-, Stickstoff- oder Kohlenstoffatomen erreicht werden.

Die hochdosierte Borimplantation verursacht Verspannungen im Kristallgitter, die zu Störungen im Wachstum der epitaktisch aufgewachsenen, nachfolgenden Siliziumschicht führen können. Dies liegt daran, daß der Atomradius von Bor kleiner ist als der von Silizium. Die Verspannungen im Kristallgitter können vermieden werden, indem gleichzeitig Germaniumatome, die einen größeren Atomradius als Silizium aufweisen, in das Kristallgitter eingebaut werden. Germanium verhält sich elektrisch neutral und stört damit nicht die Funktion der ersten dotierten Schicht 2 als Ätzstopp, kompensiert allerdings die mechanischen Verspannungen.

Wird auf dem Substrat 1 eine Maske aus einer Oxidschicht angeordnet, die die Substratoberfläche teilweise bedeckt und teilweise freilegt, kann die Implantation der ersten dotierten Schicht 2 durch die Maske erfolgen. Dadurch wird die erste dotierte Schicht 2 strukturiert ausgebildet und das Dünnen der Waferrückseite kann gleichzeitig zur Strukturierung des zu dünnenden Wafers verwendet werden. Z.B. kann der Waferrand abgetragen werden, um Beschädigungen der dünnen Chips in nachfolgenden Prozessen, z.B. durch Transport in Wafer-Boxen und durch Wafer-Handler bzw. Klemmvorrichtungen in Prozeßkammern zu vermeiden. Werden die Bereiche des Wafers, an denen der Wafer später durch Sägeprozesse in einzelne Chips zersägt wird, von der Implantation ausgenommen, wird durch den Ätzprozeß, der die Dünnung der Wafer durchführt, gleichzeitig eine Vereinzelung der Chips erreicht. Dadurch wird beispielsweise eine Schädigung beim späteren Zersägen des Wafers vermieden.

Eine strukturierte Dotierung der ersten dotierten Schicht 2 kann auch bei epitaktischer Abscheidung erreicht werden, indem auf dem Substrat zunächst eine dünne Oxidschicht abgeschieden und mit Fotolithographie strukturiert wird. Auf den offenen Flächen, an denen das Silizium freiliegt, kann selektiv eine hoch-bordotierte Siliziumschicht gewachsen werden. Dabei wächst bei der selektiven Epitaxie auf der dünnen Oxidschicht keine dotierte Siliziumschicht. Nach Entfernen der Oxidmaske kann ganzflächig epitaktisch Silizium bis zur gewünschten Zieldicke gewachsen werden.

Mit Bezug auf Figur 2 ist ein Graph mit einer ersten Achse 13 dargestellt, die die Dotierstoffkonzentration angibt, und einer zweiten Achse 14, die in die Substrattiefe weist. Weiterhin ist die Vorderseite 10 des Substrats 1 eingezeichnet und entlang der Achse 14, die in die Substrattiefe verläuft, das Dotierprofil der ersten ausdiffundierten Dotierschicht 11 und der zweiten ausdiffundierten Dotierschicht 12 dargestellt. Die erste dotierte Schicht 2 aus Figur 1 und die zweite dotierte Schicht 4 aus Figur 1 verlaufen durch einen Temperaturschritt zu den in Figur 2 dargestellten Dotierprofilen (11, 12). Nahe der Substratoberfläche 10 kompensiert dabei die zweite ausdiffundierte Dotierschicht 12 den elektrischen Effekt der ersten ausdiffundierten Dotierschicht 11.

### Bezugszeichenliste

- 1: Halbleitersubstrat
- 2: Erste dotierte Schicht
- 3: weitere Schicht
- 4: Zweite dotierte Schicht
- 5: Nutzschicht
- 6: Schaltungselementeschicht
- 7: Klebeschicht
- 8: Montageträger
- 9: Rückseite
- 10: Vorderseite
- 11: Erste ausdiffundierte Dotierschicht
- 12: Zweite ausdiffundierte Dotierschicht
- 13: Dotierstoffkonzentration
- 14: Substrattiefe
- 15: Unterer Substratbereich

## Patentansprüche

1. Verfahren zum Dünnen eines Substrats mit den Schritten:
- Bereitstellen eines Substrats (1) mit einer Vorderseite (10) und einer Rückseite (9);
- Bilden einer Nutzschicht auf der Vorderseite (10) des Substrats (1);
- Bilden einer ersten dotierten Schicht (2) in dem Substrat (1);
- naßchemisches Ätzen des Substrates (1), wobei das Substrat (1) von der Rückseite (9) gedünnt wird und die erste dotierte Schicht (2) als Ätzstopp verwendet wird.

2. Verfahren nach Anspruch 1,
**dadurch gekennzeichnet, daß**
die erste dotierte Schicht (2) epitaktisch auf die Vorderseite (10) des Substrats (1) aufgewachsen wird.

3. Verfahren nach Anspruch 2,
**dadurch gekennzeichnet, daß**
eine weitere Schicht (3) epitaktisch auf die erste dotierte Schicht (2) aufgewachsen wird.

4. Verfahren nach Anspruch 1,
**dadurch gekennzeichnet, daß**
die erste dotierte Schicht (2) durch Implantation von Dotierstoff in dem Substrat (1) gebildet wird.

5. Verfahren nach einem der Ansprüche 1 bis 4,
**dadurch gekennzeichnet, daß**
eine zweite dotierte Schicht (4) zwischen der Vorderseite (10) des Substrats (1) und der ersten dotierten Schicht (2) gebildet wird, wobei die zweite dotierte Schicht (4) mit einem zweiten Dotierstofftyp dotiert ist, der dem ersten Dotierstofftyp der ersten dotierten Schicht (2) entgegengesetzt ist.

6. Verfahren nach einem der Ansprüche 1 bis 5,
**dadurch gekennzeichnet, daß**
die zweite dotierte Schicht (4) als eine Gegendotierung für die erste dotierte Schicht (2) gebildet wird.

7. Verfahren nach einem der Ansprüche 1 bis 6,
**dadurch gekennzeichnet, daß**
eine Maske auf der Vorderseite (10) des Substrats (1) gebildet wird und als Implantationsmaske für die Bildung der ersten dotierten Schicht (2) verwendet wird, so daß die erste dotierte Schicht (2) strukturiert ausgebildet wird.

8. Verfahren nach Anspruch 7,
**dadurch gekennzeichnet, daß**
die Rückseite (9) des Substrats (1) geätzt wird, wobei die strukturierte dotierte Schicht als Ätzmaske verwendet wird und dadurch auf dem Substrat (1) angeordnete Chips voneinander separiert werden.

9. Verfahren nach Anspruch 7 oder 8,
**dadurch gekennzeichnet, daß**
die Rückseite (9) des Substrats (1) geätzt wird, wobei die strukturierte dotierte Schicht als Ätzmaske verwendet wird und dadurch der Rand des Substrats (1) entfernt wird.

10. Verfahren nach einem der Ansprüche 1 bis 9,
**dadurch gekennzeichnet, daß**
die erste dotierte Schicht (2) mit Bor p-dotiert wird.

11. Verfahren nach einem der Ansprüche 1 bis 10,
**dadurch gekennzeichnet, daß**
die erste dotierte Schicht (2) mit Germanium dotiert wird.

12. Verfahren nach einem der Ansprüche 1 bis 11,
**dadurch gekennzeichnet, daß**
die erste dotierte Schicht (2) mit Stickstoff dotiert wird.

13. Verfahren nach einem der Ansprüche 1 bis 12,
**dadurch gekennzeichnet, daß**
die erste dotierte Schicht (2) mit Kohlenstoff dotiert wird.

14. Verfahren nach einem der Ansprüche 1 bis 13,
**dadurch gekennzeichnet, daß**
auf der Vorderseite (10) des Substrats (1) eine Schaltung gebildet wird.

15. Verfahren nach einem der Ansprüche 1 bis 14,
**dadurch gekennzeichnet, daß**
das Substrat mit seiner Vorderseite (10) an einem Montageträger (8) befestigt wird.

16. Verfahren nach einem der Ansprüche 1 bis 15,
**dadurch gekennzeichnet, daß**
die Rückseite (9) des Substrats (1) abgeschliffen wird.

17. Verfahren nach einem der Ansprüche 1 bis 16,
**dadurch gekennzeichnet, daß**
die Rückseite (9) des Substrats (1) geätzt wird.
